# EUROPEAN PATENT SPECIFICATION

(11) **EP 4 057 323 B1**
(45) Date of publication and mention of the grant of the patent: **30.08.2023**
(21) Application number: 22161366.4
(22) Date of filing: 10.03.2022
(51) Int. Cl.: H01L 21/20, H01L 21/04

(54) **METHOD FOR THINNING A SILICON CARBIDE SUBSTRATE**
VERFAHREN ZUM DÜNNEN DES SILIZIUMKARBID-SUBSTRATS
PROCEDE D'AMINCISSEMENT DU SUBSTRAT EN CARBURE DE SILICIUM

(30) Priority: 10.03.2021 CN 202110260645
(43) Date of publication of application: 14.09.2022
(73) Proprietor: Huawei Digital Power Technologies Co., Ltd., Shenzhen, 518043 (CN)
(72) Inventor: HAN, Xiaobiao, Shenzhen (CN); HUANG, Boning, Shenzhen (CN); WAN, Yuxi, Shenzhen (CN); WANG, Yiyu, Shenzhen (CN)
(74) Representative: Maiwald GmbH

(56) References cited:
- US-A1- 2012 119 224
- US-A1- 2014 162 443
- US-A1- 2019 362 972
- US-A1- 2020 303 243

## Description

### TECHNICAL FIELD

This application relates to the field of semiconductor technology, and in particular, to a silicon carbide substrate, a silicon carbide device, and a substrate thinning method thereof.

### BACKGROUND

With continuous development of the semiconductor technology, the silicon carbide (Silicon Carbide, SiC) technology has become a cutting-edge technology in the semiconductor industry. In order to improve performance of a silicon carbide device, it is necessary to thin a silicon carbide substrate.

In the related art, a back surface of the silicon carbide substrate is generally ground by using a grinding apparatus, to reduce the silicon carbide substrate to specified thickness. However, Mohs' hardness of the silicon carbide substrate is very high. When the back surface of the silicon carbide substrate is ground by using the grinding apparatus, the grinding apparatus generates a great amount of wear, and a silicon carbide substrate that is ground off is completely wasted and economic benefits are low. The US 2014 / 162 443 A1 refers to a method for producing a semiconductor device. The US 2020 / 303 243 A1 refers to a method for manufacturing a semiconductor structure. The US 2012 / 119 224 A1 refers to a composite structure and a method for manufacturing a composite substrate. The US 2019 / 362 972 A1 refers to methods for processing a silicon carbide wafer and a silicon carbide semiconductor device.

### SUMMARY

Embodiments of this application provide a substrate thinning method for a silicon carbide device. A separated first substrate after the substrate is thinned may be reused, thereby avoiding complete waste of a silicon carbide substrate that is ground off, and improving economic benefits. The present application is defined in the appended independent claim.

Further implementations are disclosed in the dependent claims. In the following, implementations not falling within the scope of the claims are to be understood as examples useful for understanding the application.

According to a first aspect, an embodiment of this application provides a substrate thinning method for a silicon carbide device. The substrate thinning method includes: providing a first substrate, where the first substrate is a silicon carbide substrate, and the first substrate has a silicon surface and a carbon surface that are opposite to each other; forming a silicon carbide device on the silicon surface of the first substrate, and forming a protective layer on the silicon carbide device; performing ion implantation on the carbon surface of the first substrate; providing a second substrate; bonding an ion-implanted first substrate to the second substrate; performing high-temperature annealing on the bonded first substrate and the second substrate to combine ions implanted into the first substrate into gas; and performing separation at a position of ion implantation of the first substrate to obtain a thinned first substrate and a separated first substrate.

In this embodiment of this application, ion implantation is performed on the first substrate, the ion-implanted first substrate is bonded to the second substrate, and high-temperature annealing is performed on the bonded first substrate and the second substrate. During a high-temperature annealing process, ions within the first substrate are combined into gas, thereby generating internal stress in the first substrate to separate the first substrate at the position of ion implantation. In the related art, thinning the silicon carbide substrate by using a grinding apparatus make the grinding apparatus to generate a great amount of wear, and a silicon carbide substrate that is ground off is completely wasted. According to the substrate thinning method for the silicon carbide device provided in this embodiment of this application, a substrate of the silicon carbide device does not need to be ground. The substrate thinning method is easier to operate, and a separated first substrate after the substrate is thinned may be reused, thereby avoiding complete waste of the silicon carbide substrate that is ground off. Therefore, economic benefits are higher.

In a possible implementation, the forming a silicon carbide device on the silicon surface of the first substrate may include: forming an epitaxial layer on the silicon surface of the first substrate, and then patterning the epitaxial layer. For example, patterning may be performed on the epitaxial layer by using a process such as etching, to form the silicon carbide device. Generally, a resistivity of the first substrate is different from a resistivity of the to-be-formed silicon carbide device. Therefore, the epitaxial layer needs to be formed on the silicon surface of the first substrate, to meet an electrical requirement of the to-be-formed silicon carbide device. In actual application, N-type particles or P-type particles may be doped on the silicon surface of the first substrate, to form the epitaxial layer on the silicon surface of the first substrate. A blocking voltage and a resistivity of the epitaxial layer may be adjusted by adjusting thickness and a concentration of doping.

In a possible implementation, hydrogen ions (H⁺) or argon ions (Ar⁺) may be used to perform ion implantation on the carbon surface of the first substrate. Due to smaller sizes of the hydrogen ions or the argon ions, the hydrogen ions or the argon ions are easily implanted into the first substrate. In addition, under action of a high temperature, the hydrogen ions are easily combined into hydrogen gas, and internal stress is generated in the first substrate, so that the first substrate is separated at the position of ion implantation. Similarly, under the action of the high temperature, the argon ions are easily combined into argon gas, and internal stress is generated in the first substrate. In addition, other ions may be used to perform ion implantation on the carbon surface of the first substrate, and types of the implanted ions are not limited herein.

The substrate thinning method provided in this embodiment of this application may be implemented in a plurality of manners. The following describes in detail several manners of the substrate thinning method in this embodiment of this application.

### Manner 1:

In a possible implementation, the second substrate is a silicon carbide substrate, the second substrate has a silicon surface and a carbon surface that are opposite to each other, and the second substrate may be a lower-level silicon carbide substrate. The bonding an ion-implanted first substrate to the second substrate may include: bonding the carbon surface of the first substrate to the silicon surface of the second substrate. In this way, the first substrate and the second substrate can be bonded more easily. In addition, under action of a subsequent high temperature, a silicon atom and a carbon atom can be bonded to form a covalent bond, so that the first substrate and the second substrate are firmly bonded.

In Manner 1, thickness of a thinned first substrate may be measured, and the thickness of the thinned first substrate is compared with a preset threshold. The preset threshold may be less than thickness of the first substrate before thinning. The preset threshold is a thickness value that can meet an electrical requirement of the silicon carbide device, and may be set based on the electrical requirement of the silicon carbide device. If the thickness of the thinned first substrate does not reach the preset threshold, the following steps from a step of performing ion implantation on the carbon surface of the first substrate to a step of performing separation at a position of ion implantation of the first substrate, until thickness of a finally obtained thinned first substrate reaches the preset threshold. A third substrate is obtained each time of repetition. Because quality of the obtained third substrate is higher than that of the second substrate, specific economic benefits can be generated. A larger quantity of times of repetition indicates greater generated economic benefits.

Optionally, after the thickness of the thinned first substrate reaches the preset threshold, the method may further include removing the protective layer. After the protective layer is removed, subsequent steps may be performed. For example, the silicon carbide substrate may be cut to obtain a plurality of discrete silicon carbide devices. The method may further include packaging each silicon carbide device.

In a possible implementation, ion implantation may be performed on the carbon surface of the first substrate by using relatively small energy. In this way, a depth of ion implantation is relatively small, and thickness of an obtained separated first substrate is relatively small. The steps from performing ion implantation on the carbon surface of the first substrate to performing separation at a position of ion implantation of the first substrate need to be repeated more times, and further, the substrate thinning method has greater economic benefits. Optionally, ion implantation may be performed on the carbon surface of the first substrate by using energy of 100 keV to 1 MeV

### Manner 2:

In a possible implementation, the protective layer on the first substrate may be bonded to the second substrate. After the performing separation at a position of ion implantation of the first substrate, the substrate thinning method may further include: debonding a protective layer of the thinned first substrate and the second substrate. In other words, the protective layer on the first substrate is bonded to the second substrate. For example, materials such as glue or wax may be used to bond the protective layer to the second substrate. Compared with bonding force between the carbon surface of the first substrate and the silicon surface of the second substrate in Manner 1, bonding force between the protective layer and the second substrate in Manner 2 is relatively small. In this way, in a subsequent step, the protective layer on the first substrate and the second substrate may be debonded, and the debonded second substrate may be reused, thereby reducing process costs.

In a possible implementation, ion implantation may be performed on the carbon surface of the first substrate by using relatively large energy. In this way, a depth of ion implantation is relatively large, and thickness of a separated first substrate obtained in a subsequent step is relatively large. Optionally, energy of 1 MeV to 10 MeV may be used to perform ion implantation on the carbon surface of the first substrate.

In a possible implementation, if the thickness of the thinned first substrate does not reach the preset threshold, the following steps from a step of performing ion implantation on the carbon surface of the first substrate to a step of performing separation at a position of ion implantation of the first substrate are repeatedly performed. Based on the thickness of the first substrate and thickness of the first substrate that needs to be reduced, energy of ion implantation may be adjusted, and a quantity of times of repeatedly performing the foregoing steps may be determined. After the thickness of the thinned first substrate reaches the preset threshold, the protective layer is removed, to continue to perform the subsequent steps.

### Manner 3:

In this embodiment of this application, Manner 1 and Manner 2 may be combined. For example, Manner 2 may be used to separate a relatively thick first substrate. If thickness of a thinned first substrate does not reach the preset threshold in this case, Manner 1 may be used to continue to thin the first substrate. In addition, the first substrate may be thinned first by using Manner 1, and then the first substrate may be thinned by using Manner 2. This is not limited herein. In an actual process, based on factors such as the thickness of the first substrate, the thickness of the first substrate that needs to be reduced, and process costs, a sequence of Manner 1 and Manner 2 and a quantity of times of repeatedly thinning the first substrate by using Manner 1 and Manner 2 are designed.

According to a second aspect, which does not form part of the invention as claimed, an embodiment of this application further provides a silicon carbide device, where a substrate of the silicon carbide device is obtained by thinning any one of the foregoing substrate thinning methods. Compared with thinning a silicon carbide substrate by using a grinding apparatus in the related art, in this embodiment of this application, the substrate of the silicon carbide device is obtained by using the foregoing substrate thinning method. The substrate of the silicon carbide device does not need to be ground, and surface damage of the substrate of the silicon carbide device is relatively small. An obtained substrate of the silicon carbide device has good surface flatness.

According to a third aspect, which does not form part of the invention as claimed, an embodiment of this application further provides a silicon carbide substrate, where the silicon carbide substrate may include a first substrate and a second substrate. The first substrate may be a silicon carbide substrate, and the first substrate has a silicon surface and a carbon surface that are opposite to each other. The second substrate is a silicon carbide substrate, and the second substrate has a silicon surface and a carbon surface that are opposite to each other. The carbon surface of the first substrate is fixedly connected to the silicon surface of the second substrate. Optionally, the carbon surface of the first substrate and the silicon surface of the second substrate may be fixedly connected through a bonding process, and a carbon atom in the carbon surface of the first substrate and a silicon atom in the silicon surface of the second substrate may be bonded to form a covalent bond, so that connection between the first substrate and the second substrate is relatively firm.

In this embodiment of this application, a level of the first substrate may be higher than a level of the second substrate. Because the silicon carbide substrate has the first substrate with the higher level, the silicon carbide substrate can meet a high temperature resistance requirement and a conductive requirement for manufacturing a silicon carbide device. In specific implementation, an epitaxial layer may be made on the silicon surface of the first substrate. The epitaxial layer may be patterned to form the silicon carbide device.

### BRIEF DESCRIPTION OF DRAWINGS

FIG. 1 is a schematic flowchart of a substrate thinning method for a silicon carbide device according to an embodiment of this application;
FIG. 2 is a schematic diagram depicting structures corresponding to steps in FIG. 1;
FIG. 3 is another schematic flowchart of a substrate thinning method for a silicon carbide device according to an embodiment of this application;
FIG. 4 is a schematic diagram depicting structures corresponding to steps in FIG. 3; and
FIG. 5 is a schematic diagram depicting a structure of a silicon carbide substrate according to an embodiment of this application.

### Reference numerals:

201 - first substrate; 202 - silicon carbide device; 203 - protective layer; 204 - second substrate; 301 - third substrate.

### DESCRIPTION OF EMBODIMENTS

To make the objectives, technical solutions, and advantages of this application clearer, the following further describes this application in detail with reference to the accompanying drawings.

The substrate thinning method for a silicon carbide device provided in embodiments of this application may be applied to various silicon carbide device manufacturing processes. The silicon carbide device in embodiments of this application may be a schottky barrier diode (schottky barrier diode, SBD), a metal-oxide-semiconductor field-effect transistor (metal-oxide-semiconductor field-effect transistor, MOSFET), or a junction field-effect transistor (junction field-effect transistor, JFET). Certainly, the silicon carbide device in the embodiments of this application may alternatively be another type of device. This is not limited herein.

In a manufacturing process of the silicon carbide device, to improve production efficiency, in embodiments of this application, a plurality of silicon carbide devices are formed on a same silicon carbide substrate. A plurality of discrete grains are obtained by cutting the silicon carbide substrate through manufacturing, and then the grains are separately packaged to obtain a plurality of silicon carbide devices. Generally, the silicon carbide device is a vertical-structure device. Therefore, performance of the silicon carbide device may be improved by thinning the silicon carbide substrate. For example, a resistance of the silicon carbide device may be reduced, so that the silicon carbide device has a better positive conduction capability. A heat conduction path of the silicon carbide device is shortened, so that heat dissipation of the silicon carbide device is facilitated. In addition, the silicon carbide substrate may be cut after the silicon carbide substrate is thinned. Because thickness of the silicon carbide substrate is reduced, processing amount of a cutting process can be reduced, and defects such as edge chipping in the silicon carbide device can be prevented.

It should be noted that, in this specification, reference numerals and letters in the following accompanying drawings represent similar items. Therefore, once an item is defined in an accompanying drawing, the item does not need to be further defined or interpreted in subsequent accompanying drawings.

In descriptions of this application, it should be noted that orientation or location relationships indicated by terms "center", "above", "below", "left", "right", "vertical", "horizontal", "inner", "outer", and the like are orientation or location relationships based on the accompanying drawings, and are merely intended for conveniently describing this application and simplifying descriptions, rather than indicating or implying that an apparatus or an element in question needs to have a specific orientation or needs to be constructed and operated in a specific orientation, and therefore cannot be construed as a limitation on this application. In addition, terms "first" and "second" are merely used for a purpose of description, and shall not be understood as an indication or implication of relative importance.

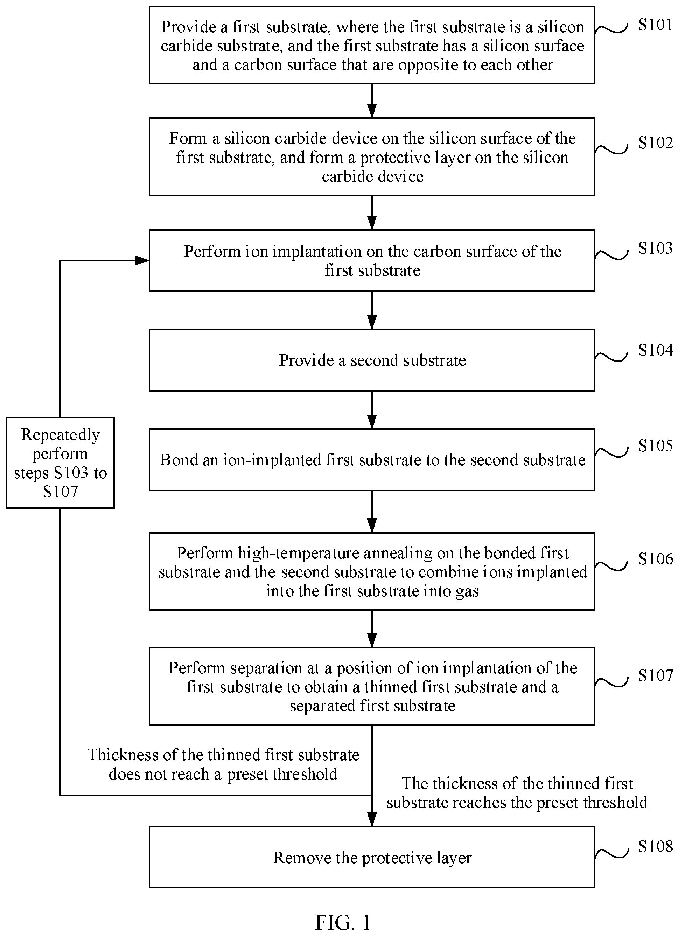

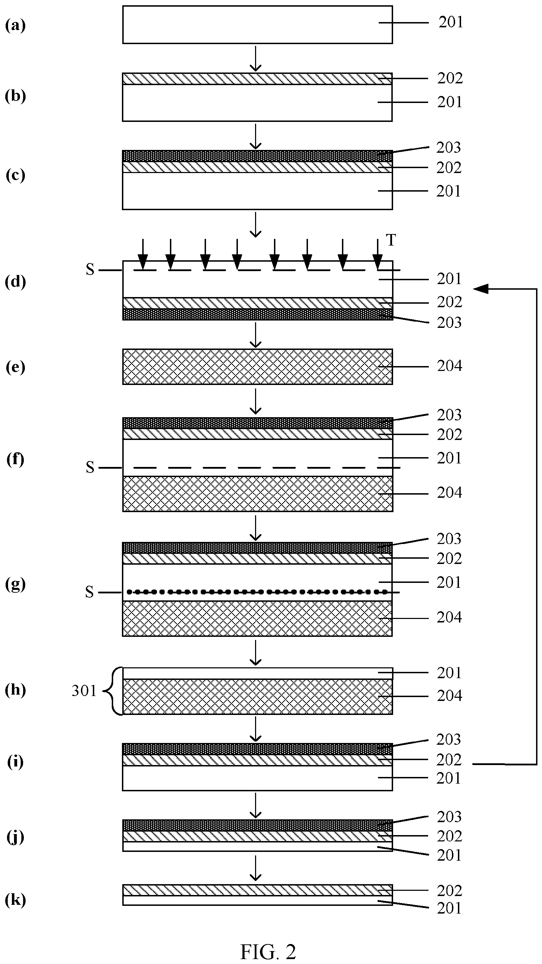

FIG. 1 is a schematic flowchart of a substrate thinning method for a silicon carbide device according to an embodiment of this application. FIG. 2 is a schematic diagram of structures corresponding to steps in FIG. 1. As shown in FIG. 1 and FIG. 2, the substrate thinning method for a silicon carbide device according to an embodiment of this application includes the following steps.

S101: Provide a first substrate 201, as shown in (a) in FIG. 2, where the first substrate 201 is a silicon carbide substrate, and the first substrate has a silicon surface and a carbon surface that are opposite to each other.

S102: Form a silicon carbide device 202 on the silicon surface of the first substrate 201, as shown in (b) in FIG. 2, and form a protective layer 203 on the silicon carbide device 202 as shown in (c) in FIG. 2, where the protective layer 203 may protect the silicon carbide device 202, to avoid damage to the silicon carbide device 202 caused by a subsequent operation. Optionally, the protective layer 203 may be a photoresist, an adhesive tape, or the like.

S103: Perform ion implantation on the carbon surface of the first substrate 201, as shown in (d) in FIG. 2, where an arrow T in the figure represents ion implantation, and a dashed line S represents a position of ion implantation.

S104: Provide a second substrate 204, as shown in (e) in FIG. 2.

S105: Bond an ion-implanted first substrate 201 to the second substrate 204, as shown in (f) in FIG. 2.

S106: Perform high-temperature annealing on the bonded first substrate 201 and the second substrate 204, as shown in (g) in FIG. 2, to combine ions implanted into the first substrate 201 into gas, where black dots are used to represent the gas.

S107: Perform separation at a position of ion implantation (at a dashed line S) of the first substrate 201, as shown in (g) in FIG. 2, to obtain a thinned first substrate 201, as shown in (i) in FIG. 2, and obtain a separated first substrate 201, as shown in (h) in FIG. 2.

In this embodiment of this application, ion implantation is performed on the first substrate, the ion-implanted first substrate is bonded to the second substrate, and high-temperature annealing is performed on the bonded first substrate and the second substrate. During a high-temperature annealing process, ions within the first substrate are combined into gas, thereby generating internal stress in the first substrate to separate the first substrate at the position of ion implantation. In the related art, thinning a silicon carbide substrate by using a grinding apparatus makes the grinding apparatus to generate a great amount of wear, and a silicon carbide substrate that is ground off is completely wasted. According to the substrate thinning method for the silicon carbide device provided in this embodiment of this application, a substrate of the silicon carbide device does not need to be ground. The substrate thinning method is easier to operate, and a separated first substrate after the substrate is thinned may be reused, thereby avoiding complete waste of the silicon carbide substrate that is ground off. Therefore, economic benefits are higher.

In the foregoing step S101, the first substrate is the silicon carbide substrate, where the silicon carbide includes silicon atoms and carbon atoms. The silicon carbide substrate includes a silicon atom layer and a carbon atom layer that are alternately arranged. Therefore, a surface on one side of the silicon carbide substrate is a silicon atom layer, namely, the silicon surface. A surface on the other side of the silicon carbide substrate is a carbon atom layer, namely, the carbon surface.

In the foregoing step S102, the forming a silicon carbide device on the silicon surface of the first substrate may include: forming an epitaxial layer on the silicon surface of the first substrate 201, as shown in (b) in FIG. 2, and then patterning the epitaxial layer. For example, patterning may be performed on the epitaxial layer by using a process such as etching, to form the silicon carbide device 202. Generally, a resistivity of the first substrate is different from a resistivity of the to-be-formed silicon carbide device. Therefore, the epitaxial layer needs to be formed on the silicon surface of the first substrate, to meet an electrical requirement of the to-be-formed silicon carbide device. In actual application, N-type particles or P-type particles may be doped on the silicon surface of the first substrate, to form the epitaxial layer on the silicon surface of the first substrate. A blocking voltage and a resistivity of the epitaxial layer may be adjusted by adjusting thickness and a concentration of doping.

In the foregoing step S103, as shown in (d) in FIG. 2, hydrogen ions (H⁺) or argon ions (Ar⁺) may be used to perform ion implantation on the carbon surface of the first substrate 201. Due to smaller sizes of the hydrogen ions or the argon ions, the hydrogen ions or the argon ions are easily implanted into the first substrate 201. Further, in the subsequent step S106, as shown in (g) in FIG. 2, under action of a high temperature, the hydrogen ions are easily combined into hydrogen gas, and internal stress is generated in the first substrate 201, so that the first substrate 201 is separated at the position of ion implantation. Similarly, under the action of the high temperature, the argon ions are easily combined into argon gas, and internal stress is generated in the first substrate 201. In addition, other ions may be used to perform ion implantation on the carbon surface of the first substrate 201, and types of the implanted ions are not limited herein. In this embodiment of this application, the position of ion implantation may be understood as a position at which an ion concentration is relatively high in the first substrate 201 after ion implantation is performed. During specific implementation, the position of ion implantation may be controlled by adjusting energy of ion implantation.

In the foregoing step S105, the ion-implanted first substrate 201 is bonded to the second substrate 204, as shown in (f) in FIG. 2. The second substrate 204 may support the first substrate 201. In a subsequent step S107, as shown in (g) in FIG. 2, due to supporting action of the second substrate 204, the first substrate 201 can be more easily separated at the position of ion implantation, and the separated first substrate 201 or the thinned first substrate 201 can be prevented from being damaged in the separation process. In the foregoing step S107, because the first substrate 201 has relatively large internal stress at the position of ion implantation (at the dashed line S), in an actual operation process, only lateral thrust force needs to be applied to a side wall other than the position of ion implantation of the first substrate 201. In this way, the first substrate 201 can be separated at the position of ion implantation. For example, a device similar to an ejector pin may be used to apply thrust force to the sidewall of the first substrate 201.

The substrate thinning method provided in this embodiment of this application may be implemented in a plurality of manners. The following describes in detail several manners of the substrate thinning method in this embodiment of this application with reference to the accompanying drawings.

### Manner 1:

In the foregoing step S104, the second substrate 204 is provided, as shown in (e) in FIG. 2. The second substrate 204 is a silicon carbide substrate, and the second substrate has a silicon surface and a carbon surface that are opposite to each other. In the foregoing step S105, the carbon surface of the ion-implanted first substrate 201 is bonded to the silicon surface of the second substrate 204, as shown in (f) in FIG. 2.

In Manner 1 of this application, the second substrate is also the silicon carbide substrate. In this way, in step S105, the carbon surface of the first substrate and the silicon surface of the second substrate are bonded, so that the first substrate and the second substrate are more easily bonded. In addition, under the action of the high temperature in the subsequent step S 106, a silicon atom and a carbon atom can be bonded to form a covalent bond, so that the first substrate and the second substrate are firmly bonded.

In actual application, silicon carbide substrates may be classified into a plurality of levels based on degrees of internal defects in crystals, surface processing quality, and the like. A higher level of the silicon carbide substrate indicates better quality of the silicon carbide substrate and a higher price of the silicon carbide substrate. In step S 101 in Manner 1, the first substrate may be a silicon carbide substrate of a relatively high level, and in step S104 in Manner 1, the second substrate may be a silicon carbide substrate of a relatively low level. In other words, a level of the first substrate is higher than a level of the second substrate.

In step S107, as shown in (h) in FIG. 2, after the first substrate 201 is separated at the position of ion implantation, the obtained separated first substrate 201 and the second substrate 204 are still firmly bonded. For ease of description, the separated first substrate 201 and the separated second substrate 204 may be referred to as a third substrate 301. The third substrate 301 has a silicon carbide substrate of a higher level (namely, the first substrate 201), and the second substrate 204 in the third substrate 301 is also the silicon carbide substrate. Therefore, the third substrate 301 can meet a high-temperature resistance requirement and a conductive requirement for manufacturing a silicon carbide device. Therefore, the epitaxial layer may be formed on the silicon surface of the first substrate 201 in the third substrate 301, to manufacture the silicon carbide device. In addition, in Manner 1, the second substrate 204 provided in step S104 is a silicon carbide substrate of a low level. Compared with the second substrate 204, the third substrate 301 obtained in step 5107 has a silicon carbide substrate of a higher level. Quality of the third substrate 301 is better, and the third substrate 301 may continue to manufacture the silicon carbide device. Therefore, after step S105 to step S107, quality of the silicon carbide substrate can be improved, and economic benefits of the silicon carbide substrate can be improved.

In Manner 1, after step S107, thickness of the thinned first substrate may be measured, and the thickness of the thinned first substrate is compared with a preset threshold. The preset threshold may be less than thickness of the first substrate before thinning. The preset threshold is a thickness value that can meet an electrical requirement of the silicon carbide device and may be set based on the electrical requirement of the silicon carbide device. If the thickness of the thinned first substrate does not reach the preset threshold, steps from step S103 to step S107 in FIG. 1 may be repeatedly performed, so that a finally obtained thickness of the thinned first substrate reaches the preset threshold. As shown in (j) in FIG. 2, after the thickness of the thinned first substrate 201 reaches the preset threshold, the method may further include: removing the protective layer, to obtain a structure shown in (k) in FIG. 2. After the protective layer is removed, subsequent steps may be easily performed. For example, the silicon carbide substrate may be cut to obtain a plurality of discrete silicon carbide devices, and each silicon carbide device may be packaged.

In manner 1 of this embodiment of this application, each time S103 to S107 in FIG. 1 are repeated, a third substrate is obtained in step S107. Because quality of the obtained third substrate is higher than that of the second substrate provided in step S104, specific economic benefits can be generated. A larger quantity of times of performing S103 to S107 indicates greater generated economic benefits. Optionally, in step S103 of Manner 1, as shown in (d) in FIG. 2, ion implantation may be performed on the carbon surface of the first substrate 201 by using relatively small energy. In this way, a depth of ion implantation is relatively small. As shown in (h) in FIG. 2, the thickness of the separated first substrate 201 obtained in step S107 is relatively small. In actual application, energy of 100 keV to 1 MeV may be used to perform ion implantation on the carbon surface of the first substrate 201. The depth of ion implantation may be in a range of 0.5 µm to 10 µm, and the thickness of the obtained separated first substrate 201 may also be in the range of 0.5 µm to 10 µm. For example, energy of about 200 keV may be used to perform ion implantation on the carbon surface of the first substrate 201, so that the depth of ion implantation is about 1 µm, and the thickness of the obtained separated first substrate 201 is about 1 µm. Therefore, ion implantation is performed on the first substrate 201 with relatively small energy, and the thickness of the obtained separated first substrate 201 is relatively small, so that step S103 to step S107 need to be repeated more times. Further, economic benefits of the substrate thinning method are relatively large. In step S103 of Manner 1, concentration of ion implantation may be in a range of 10¹⁶/cm² to 10¹⁸/cm². In order to increase ion activity and reduce implantation damage, ion implantation may be performed at a high temperature. For example, ion implantation may be performed at a temperature of about 500°C.

For example, if the thickness of the first substrate before thinning is about 350 µm and the preset threshold is 100 µm, in step S103, energy of 200 keV is used to perform ion implantation, so that the depth of ion implantation may be about 1 µm. In addition, a surface of the thinned first substrate obtained in step S107 is relatively rough, and the surface of the thinned first substrate may be processed by using a surface processing process such as polishing. In the surface processing process, the thickness of the first substrate is lost to a specific extent. Therefore, each time the steps from step S103 to step S107 are repeated, the first substrate may be thinned by about 10 µm. Therefore, the steps from step S103 to step S107 need to be repeated tens of times, tens of third substrates may be obtained, and economic benefits are greater.

Optionally, as shown in FIG. 1, the substrate thinning method in this embodiment of this application may further include S108: Remove the protective layer after the thickness of the thinned first substrate 201 shown in (i) in FIG. 2 reaches the preset threshold, to obtain the structure shown in (k) in FIG. 2.

### Manner 2:

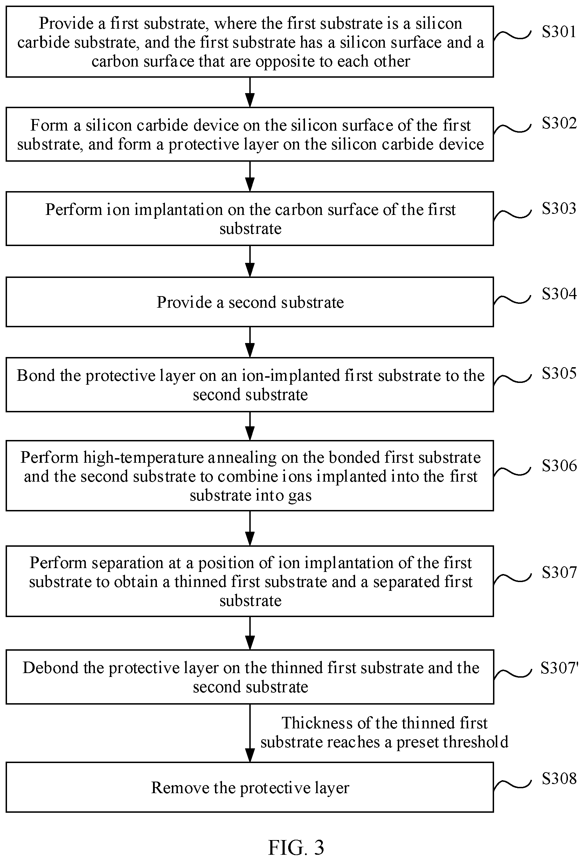

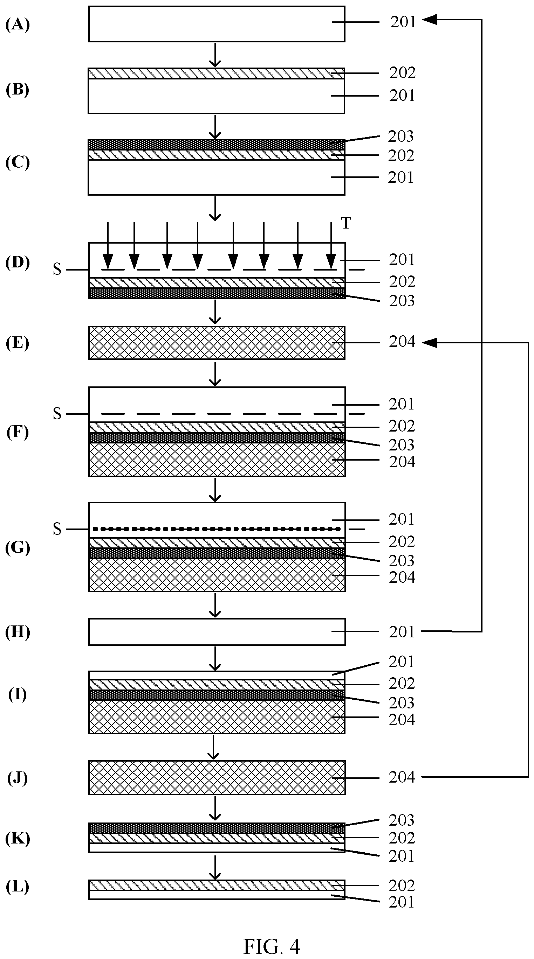

FIG. 3 is another schematic flowchart of a substrate thinning method for a silicon carbide device according to an embodiment of this application. FIG. 4 is a schematic diagram of structures corresponding to steps in FIG. 3. As shown in FIG. 3 and FIG. 4, the substrate thinning method in an embodiment of this application may include the following steps.

S301: Provide a first substrate 201, as shown in (A) in FIG. 4, where the first substrate 201 is a silicon carbide substrate, and the first substrate has a silicon surface and a carbon surface that are opposite to each other.

S302: Form a silicon carbide device 202 on the silicon surface of the first substrate 201, as shown in (B) in FIG. 4, and form a protective layer 203 on the silicon carbide device 202, as shown in (C) in FIG. 4.

S303: Perform ion implantation on the carbon surface of the first substrate 201, as shown in (D) in FIG. 4, where an arrow T in the figure represents ion implantation, and a dashed line S represents a position of ion implantation.

S304: Provide a second substrate 204, as shown in (E) in FIG. 4, where the second substrate 204 supports the first substrate. The second substrate 204 may be a silicon carbide substrate, or the second substrate 204 may be another type of substrate. This is not limited herein.

S305: Bond an ion-implanted first substrate 201 to the second substrate 204, as shown in (F) in FIG. 4. Optionally, the protective layer 203 on the first substrate 201 and the second substrate 204 may be bonded.

S306: Perform high-temperature annealing on the bonded first substrate 201 and the second substrate 204, as shown in (G) in FIG. 4, to combine ions implanted into the first substrate 201 into gas, where black dots are used to represent the gas.

S307: Perform separation at a position of ion implantation (at the dashed line S) of the first substrate 201, as shown in (G) in FIG. 4, to obtain a thinned first substrate 201 shown in (I) in FIG. 4, and obtain a separated first substrate 201, as shown in (H) in FIG. 4.

S307': Debond the protective layer 203 on the thinned first substrate 201 and the second substrate 204, as shown in (I) in FIG. 4, to obtain the second substrate 204 shown in (J) in FIG. 4, and obtain the first substrate 201 shown in (K) in FIG. 4.

S308: Remove the protective layer 203 to obtain a structure shown in (L) in FIG. 4 after thickness of the thinned first substrate 201 shown in (I) in FIG. 4 reaches a preset threshold.

In Manner 2 of this application, in step S305, as shown in (F) in FIG. 4, the silicon surface of the first substrate 201 is bonded to the second substrate 204. In other words, the protective layer 203 on the first substrate 201 is bonded to the second substrate 204. For example, the protective layer 203 may be bonded to the second substrate 204 by using a material such as glue or wax. Compared with bonding force between the carbon surface of the first substrate and the silicon surface of the second substrate in Manner 1, bonding force between the protective layer 203 and the second substrate 204 in Manner 2 is relatively small. In this way, in the subsequent step S307', the protective layer on the first substrate and the second substrate may be debonded, as shown in (1) in FIG. 4, and a debonded second substrate 204 may be reused when step S304 is performed, thereby reducing process costs.

In addition, in step S303 of Manner 2, as shown in (D) in FIG. 4, ion implantation may be performed on the carbon surface of the first substrate 201 by using relatively large energy. In this way, a depth of ion implantation is relatively large. As shown in (H) in FIG. 4, the thickness of the separated first substrate 201 obtained in the subsequent step S307 is relatively large. In actual application, energy of 1 MeV to 10 MeV may be used to perform ion implantation on the carbon surface of the first substrate. The depth of ion implantation may be in a range of 10 µm to 450 µm, and the thickness of the obtained separated first substrate 201 may also be 10 µm to 450 µm. For example, energy of about 4 MeV may be used to perform ion implantation on the carbon surface of the first substrate, so that the depth of ion implantation may be about 100 µm, and the thickness of the obtained separated first substrate 201 is about 100 µm. In this way, the separated first substrate 201 obtained in step S307 may continue to be used to manufacture the silicon carbide device. In other words, the obtained separated first substrate 201 may be reused, thereby improving utilization of the silicon carbide substrate and reducing manufacturing costs. In step S303 of Manner 2, concentration of ion implantation may be in a range of 10¹⁶/cm² to 10¹⁸/cm². A concentration of ion implantation in Manner 2 may be greater than a concentration of ion implantation in Manner 1. Further, in order to increase ion activity and reduce implantation damage, ion implantation may be performed at a high temperature. For example, ion implantation may be performed at a temperature of about 500°C.

In Manner 2 of this application, each time step S303 to step S307 are performed, one separated first substrate 201 shown in (H) in FIG. 4 can be obtained. During specific implementation, if the thickness of the thinned first substrate does not reach the preset threshold, step S303 to step S307 may be repeatedly performed. The energy of ion implantation in step S303 may be adjusted based on the thickness of the first substrate and the thickness of the first substrate that needs to be thinned. A quantity of times of repeatedly performing step S303 to step S307 is determined based on the thickness of the first substrate and the thickness of the first substrate that needs to be reduced.

### Manner 3:

In this embodiment of this application, Manner 1 and Manner 2 may be combined. For example, Manner 2 may be used to separate a relatively thick first substrate. If thickness of a thinned first substrate does not reach the preset threshold in this case, Manner 1 may be used to continue to thin the first substrate. In addition, the first substrate may be thinned first by using Manner 1, and then the first substrate may be thinned by using Manner 2. This is not limited herein. In an actual process, based on factors such as the thickness of the first substrate, thickness of the first substrate that needs to be reduced, and process costs, a sequence of Manner 1 and Manner 2 and a quantity of repeatedly thinning the first substrate by using Manner 1 and Manner 2 are designed.

Based on a same technical concept, an embodiment of this application further provides a silicon carbide device, which does not form part of the invention as claimed, where a substrate of the silicon carbide device is obtained by thinning any one of the foregoing substrate thinning methods. Compared with thinning a silicon carbide substrate by using a grinding apparatus in the related art, in this embodiment of this application, the substrate of the silicon carbide device is obtained by using the foregoing substrate thinning method. The substrate of the silicon carbide device does not need to be ground, and surface damage of the substrate of the silicon carbide device is relatively small. An obtained substrate of the silicon carbide device has good surface flatness.

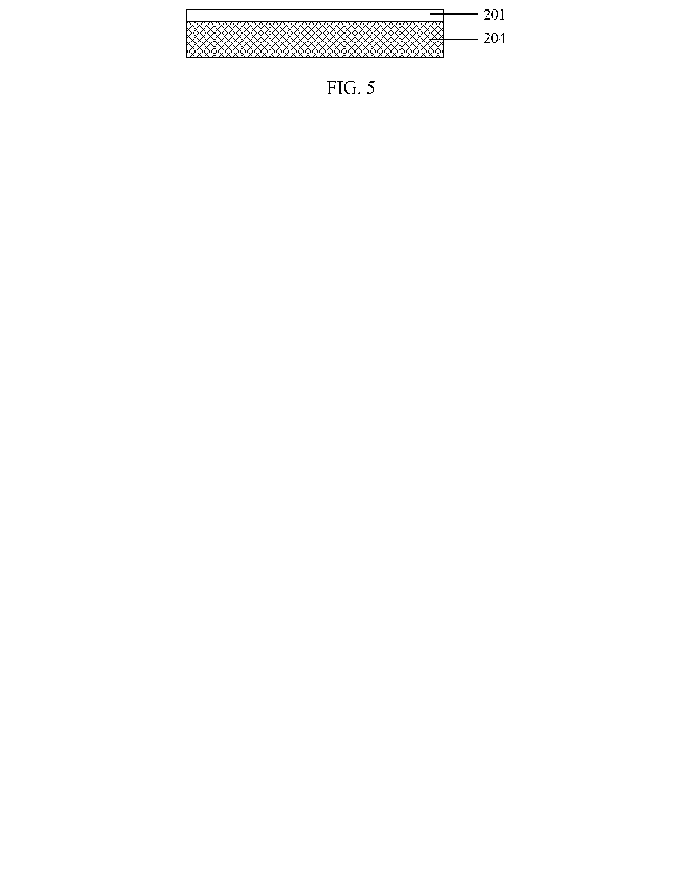

Based on a same technical concept, an embodiment of this application further provides a silicon carbide substrate, which does not form part of the invention as claimed. FIG. 5 is a schematic diagram depicting a structure of a silicon carbide substrate. As shown in FIG. 5, the silicon carbide substrate may include a first substrate 201 and a second substrate 204. The first substrate 201 may be a silicon carbide substrate, and the first substrate 201 has a silicon surface and a carbon surface that are opposite to each other. The second substrate 204 is a silicon carbide substrate, and the second substrate 204 has a silicon surface and a carbon surface that are opposite to each other. The carbon surface of the first substrate 201 is fixedly connected to the silicon surface of the second substrate 204. Optionally, the carbon surface of the first substrate 201 and the silicon surface of the second substrate 204 may be fixedly connected through a bonding process, and a carbon atom in the carbon surface of the first substrate 201 and a silicon atom on the silicon surface of the second substrate 204 may be bonded to form a covalent bond, so that connection between the first substrate 201 and the second substrate 204 is relatively firm.

In this embodiment of this application, the silicon carbide substrate, which does not form part of the invention as claimed, may be the third substrate obtained in step S107 in the foregoing Manner 1. In other words, a level of the first substrate 201 may be higher than a level of the second substrate 204. Because the silicon carbide substrate has the first substrate 201 with the higher level, the silicon carbide substrate can meet a high temperature resistance requirement and a conductive requirement for manufacturing a silicon carbide device. In specific implementation, an epitaxial layer may be made on the silicon surface of the first substrate 201. The epitaxial layer may be patterned to form the silicon carbide device.

The foregoing descriptions are merely specific implementations of this application, but the protection scope of this application is not limited thereto. The scope of the present invention is defined by the appended claims.

## Claims

1. A substrate thinning method for a silicon carbide device, comprising:
providing (S101) a first substrate (201), wherein the first substrate (201) is a silicon carbide substrate, and the first substrate (201) has a silicon surface and a carbon surface that are opposite to each other;
forming (S102) a silicon carbide device (202)
on the silicon surface of the first substrate (201), and forming a protective layer (203) on the silicon carbide device;
performing (S103) ion implantation on the carbon surface of the first substrate (201);
providing (S104) a second substrate (204);
bonding (S105) an ion-implanted first substrate to the second substrate (204);
performing (S106) high-temperature annealing on the bonded first substrate (201) and the second substrate (204) to combine ions implanted into the first substrate (201) into gas; and
performing (S107) separation at a position of ion implantation of the first substrate (201) to obtain a thinned first substrate (201) and a separated first substrate (201).

2. The substrate thinning method according to claim 1, wherein the second substrate (204) is a silicon carbide substrate, and the second substrate (204) has a silicon surface and a carbon surface that are opposite to each other; and
the bonding an ion-implanted first substrate (201) to the second substrate (204) comprises:
bonding the carbon surface of the first substrate (201) to the silicon surface of the second substrate (204).

3. The substrate thinning method according to claim 1 or 2, wherein if thickness of the thinned first substrate (201) does not reach a preset threshold, steps from a step of performing ion implantation on the carbon surface of the first substrate (201) to a step of performing separation at a position of ion implantation of the first substrate (201) are repeatedly performed, until thickness of a finally obtained thinned first substrate (201) reaches the preset threshold.

4. The substrate thinning method according to any one of claims 1 to 3, wherein the performing ion implantation on the carbon surface of the first substrate (201) comprises:
performing ion implantation on the carbon surface of the first substrate (201) by using energy of 100 keV to 1 MeV

5. The substrate thinning method according to claim 1, wherein the bonding an ion-implanted first substrate (201) to the second substrate (204) comprises:
bonding the protective layer on the first substrate (201) to the second substrate (204).

6. The substrate thinning method according to claim 5, wherein after the performing separation at a position of ion implantation of the first substrate (201), the method further comprises:
debonding a protective layer on the thinned first substrate (201) and the second substrate (204).

7. The substrate thinning method according to claim 5, wherein the performing ion implantation on the carbon surface of the first substrate (201) comprises:
performing ion implantation on the carbon surface of the first substrate (201) by using energy of 1 MeV to 10 MeV

8. The substrate thinning method according to any one of claims 1 to 7, wherein after the thickness of the thinned first substrate (201) reaches the preset threshold, the method further comprises:
removing the protective layer.

9. The substrate thinning method according to any one of claims 1 to 7, wherein the performing ion implantation on the carbon surface of the first substrate (201) comprises:
performing ion implantation on the carbon surface of the first substrate (201) by using hydrogen ions or argon ions.

10. The substrate thinning method according to any one of claims 1 to 7, wherein the forming a silicon carbide device on the silicon surface of the first substrate (201) comprises:
forming an epitaxial layer on the silicon surface of the first substrate (201); and
patterning the epitaxial layer to form the silicon carbide device.

## Patentansprüche

1. Substratdünnungsverfahren für eine Siliziumkarbidvorrichtung, umfassend:
Bereitstellen (S101) eines ersten Substrats (201), wobei das erste Substrat (201) ein Siliziumkarbidsubstrat ist und das erste Substrat (201) eine Siliziumoberfläche und eine Kohlenstoffoberfläche, die einander gegenüberliegen, aufweist;
Ausbilden (S102) einer Siliziumkarbidvorrichtung (202) auf der Siliziumoberfläche des ersten Substrats (201) und Ausbilden einer Schutzschicht (203) auf der Siliziumkarbidvorrichtung;
Durchführen (S103) einer Ionenimplantation auf der Kohlenstoffoberfläche des ersten Substrats (201);
Bereitstellen (S104) eines zweiten Substrats (204);
Binden (S105) eines ionenimplantierten ersten Substrats an das zweite Substrat (204);
Durchführen (S106) eines Hochtemperaturglühens an dem gebundenen ersten Substrat (201) und dem zweiten Substrat (204) zum Verbinden von in das erste Substrat (201) implantierten Ionen zu Gas und
Durchführen (S107) einer Trennung an einer Ionenimplantationsposition des ersten Substrats (201) zum Erhalten eines gedünnten ersten Substrats (201) und eines getrennten ersten Substrats (201).

2. Substratdünnungsverfahren nach Anspruch 1, wobei das zweite Substrat (204) ein Siliziumkarbidsubstrat ist und das zweite Substrat (204) eine Siliziumoberfläche und eine Kohlenstoffoberfläche, die einander gegenüberliegen, aufweist; und
das Binden eines ionenimplantierten ersten Substrats (201) an das zweite Substrat (204) Folgendes umfasst:
Binden der Kohlenstoffoberfläche des ersten Substrats (201) an die Siliziumoberfläche des zweiten Substrats (204).

3. Substratdünnungsverfahren nach Anspruch 1 oder 2, wobei, wenn die Dicke des gedünnten ersten Substrats (201) einen vorab festgelegten Schwellenwert nicht erreicht, die Schritte von einem Schritt des Durchführens einer Ionenimplantation auf der Kohlenstoffoberfläche des ersten Substrats (201) bis zu einem Schritt des Durchführens einer Trennung an einer Ionenimplantationsposition des ersten Substrats (201) wiederholt durchgeführt werden, bis die Dicke eines letztlich erhaltenen gedünnten ersten Substrats (201) den vorab festgelegten Schwellenwert erreicht.

4. Substratdünnungsverfahren nach einem der Ansprüche 1 bis 3, wobei das Durchführen der Ionenimplantation auf der Kohlenstoffoberfläche des ersten Substrats (201) Folgendes umfasst:
Durchführen der Ionenimplantation auf der Kohlenstoffoberfläche des ersten Substrats (201) unter Einsatz von Energie von 100 keV bis 1 MeV.

5. Substratdünnungsverfahren nach Anspruch 1, wobei das Binden eines ionenimplantierten ersten Substrats (201) an das zweite Substrat (204) Folgendes umfasst:
Binden der Schutzschicht auf dem ersten Substrat (201) an das zweite Substrat (204).

6. Substratdünnungsverfahren nach Anspruch 5, wobei nach dem Durchführen der Trennung an einer Ionenimplantationsposition des ersten Substrats (201) das Verfahren ferner Folgendes umfasst:
Ablösen einer Schutzschicht auf dem gedünnten ersten Substrat (201) und dem zweiten Substrat (204).

7. Substratdünnungsverfahren nach Anspruch 5, wobei das Durchführen der Ionenimplantation auf der Kohlenstoffoberfläche des ersten Substrats (201) Folgendes umfasst:
Durchführen der Ionenimplantation auf der Kohlenstoffoberfläche des ersten Substrats (201) unter Einsatz von Energie von 1 MeV bis 10 MeV.

8. Substratdünnungsverfahren nach einem der Ansprüche 1 bis 7, wobei, nachdem die Dicke des gedünnten ersten Substrats (201) den vorab festgelegten Schwellenwert erreicht, das Verfahren ferner Folgendes umfasst:
Entfernen der Schutzschicht.

9. Substratdünnungsverfahren nach einem der Ansprüche 1 bis 7, wobei das Durchführen der Ionenimplantation auf der Kohlenstoffoberfläche des ersten Substrats (201) Folgendes umfasst:
Durchführen der Ionenimplantation auf der Kohlenstoffoberfläche des ersten Substrats (201) unter Einsatz von Wasserstoffionen oder Argonionen.

10. Substratdünnungsverfahren nach einem der Ansprüche 1 bis 7, wobei das Ausbilden einer Siliziumkarbidvorrichtung auf der Siliziumoberfläche des ersten Substrats (201) Folgendes umfasst:
Ausbilden einer Epitaxieschicht auf der Siliziumoberfläche des ersten Substrats (201) und Strukturieren der Epitaxieschicht zum Ausbilden der Siliziumkarbidvorrichtung.

## Revendications

1. Procédé d'amincissement du substrat pour un dispositif en carbure de silicium, comprenant :
la fourniture (S101) d'un premier substrat (201), le premier substrat (201) étant un substrat en carbure de silicium, et le premier substrat (201) ayant une surface en silicium et une surface en carbone qui sont opposées l'une à l'autre ;
la formation (S102) d'un dispositif en carbure de silicium (202) sur la surface en silicium du premier substrat (201), et la formation d'une couche protectrice (203) sur le dispositif en carbure de silicium ;
la réalisation (S103) d'une implantation ionique sur la surface en carbone du premier substrat (201) ;
la fourniture (S104) d'un deuxième substrat (204) ;
la liaison (S105) d'un premier substrat à implantation ionique au deuxième substrat (204) ;
la réalisation (S106) d'un recuit à haute température sur le premier substrat (201) lié et le deuxième substrat (204) pour combiner les ions implantés dans le premier substrat (201) en gaz ; et
la réalisation (S107) d'une séparation au niveau d'une position d'implantation ionique du premier substrat (201) pour obtenir un premier substrat (201) aminci et un premier substrat (201) séparé.

2. Procédé d'amincissement du substrat selon la revendication 1, dans lequel le deuxième substrat (204) est un substrat en carbure de silicium, et le deuxième substrat (204) a une surface en silicium et une surface en carbone qui sont opposées l'une à l'autre ; et
la liaison d'un premier substrat à implantation ionique (201) au deuxième substrat (204) comprend :
la liaison de la surface en carbone du premier substrat (201) à la surface en silicium du deuxième substrat (204).

3. Procédé d'amincissement du substrat selon la revendication 1 ou 2, dans lequel si l'épaisseur du premier substrat (201) aminci n'atteint pas un seuil prédéterminé, les étapes allant d'une étape consistant à réaliser une implantation ionique sur la surface en carbone du premier substrat (201) à une étape consistant à réaliser une séparation au niveau d'une position d'implantation ionique du premier substrat (201) sont réalisées de manière répétée, jusqu'à ce que l'épaisseur d'un premier substrat (201) aminci finalement obtenu atteigne le seuil prédéterminé.

4. Procédé d'amincissement du substrat selon l'une quelconque des revendications 1 à 3, dans lequel la réalisation d'une implantation ionique sur la surface en carbone du premier substrat (201) comprend :
la réalisation d'une implantation ionique sur la surface en carbone du premier substrat (201) en utilisant une énergie allant de 100 keV à 1 MeV.

5. Procédé d'amincissement du substrat selon la revendication 1, dans lequel la liaison d'un premier substrat à implantation ionique (201) au deuxième substrat (204) comprend :
la liaison de la couche protectrice sur le premier substrat (201) au deuxième substrat (204).

6. Procédé d'amincissement du substrat selon la revendication 5, après la réalisation d'une séparation au niveau d'une position d'implantation ionique du premier substrat (201), le procédé comprenant en outre :
le fait de délier une couche protectrice sur le premier substrat (201) aminci et le deuxième substrat (204).

7. Procédé d'amincissement du substrat selon la revendication 5, dans lequel la réalisation d'une implantation ionique sur la surface en carbone du premier substrat (201) comprend :
la réalisation d'une implantation ionique sur la surface en carbone du premier substrat (201) en utilisant une énergie allant de 1 MeV à 10 MeV.

8. Procédé d'amincissement du substrat selon l'une quelconque des revendications 1 à 7, après que l'épaisseur du premier substrat (201) aminci a atteint le seuil prédéterminé, le procédé comprenant en outre :
le retrait de la couche protectrice.

9. Procédé d'amincissement du substrat selon l'une quelconque des revendications 1 à 7, dans lequel la réalisation d'une implantation ionique sur la surface en carbone du premier substrat (201) comprend :
la réalisation d'une implantation ionique sur la surface en carbone du premier substrat (201) en utilisant des ions d'hydrogène ou des ions d'argon.

10. Procédé d'amincissement du substrat selon l'une quelconque des revendications 1 à 7, dans lequel la formation d'un dispositif en carbure de silicium sur la surface en silicium du premier substrat (201) comprend :
la formation d'une couche épitaxiale sur la surface en silicium du premier substrat (201) ; et
le modelage de la couche épitaxiale pour former le dispositif en carbure de silicium.
